**Europäisches Patentamt**

**European Patent Office**

**Office européen des brevets**

(19)

(11) Veröffentlichungsnummer: **0 446 686 A1**

## (12) EUROPÄISCHE PATENTANMELDUNG

(21) Anmeldenummer: **91102558.3**

(22) Anmeldetag: **21.02.91**

(51) Int. Cl.5: **H01L 31/048**

(30) Priorität: **08.03.90 DE 4007377**

(43) Veröffentlichungstag der Anmeldung:
**18.09.91 Patentblatt 91/38**

(84) Benannte Vertragsstaaten:
**DE FR GB IT**

(71) Anmelder: **Siemens Solar GmbH**
**Buchenallee 3**
**W-5060 Bergisch Gladbach 1(DE)**

(72) Erfinder: **Bednorz, Klaus**
**Leopoldstrasse 138**
**W-8000 München 40(DE)**
Erfinder: **Riermeier, Manfred**
**Finkenweg 1**
**W-8059 Oberneuching(DE)**

(74) Vertreter: **Fuchs, Franz-Josef, Dr.-Ing.**
**Postfach 22 13 17**
**W-8000 München 22(DE)**

(54) Verfahren zur Herstellung eines Gross-Solarmoduls.

(57) Ein Verfahren zur Herstellung eines Groß-Solarmoduls durch Kleben von mehreren Solarmodul-Laminaten auf einem gemeinsamen Gestellrahmen soll eine dauerhafte Verbindung der Solarmodule auf dem Gestellrahmen auch unter ungünstigen Umständen ermöglichen. Als Kleber wird ein Silikon mit nicht-korrosiver Vernetzungsart verwendet.

EP 0 446 686 A1

Die Erfindung betrifft ein Verfahren zur Herstellung eines Groß-Solarmoduls nach dem Oberbegriff des Patentanspruchs 1.

Unter einem Solarmodul-Laminat wird ein Solargenerator verstanden, dessen Solarzellen mit zugehörigen elektrischen Anschlüssen und Verbindungsleitungen in einem Verbund aus einem Träger bzw. Rückseitenabdeckung, einer elastischen Schmelzkleberfolie und einer Glasscheibe eingebettet sind. Bevorzugt ist dabei an rahmenlose Solarmodul-Laminate gedacht. Als Träger bzw. Rückseitenabdeckung kommen dabei eine Glasscheibe, ein Blech, eine Folie oder dergleichen in Frage. Ein solches Solarmodul-Laminat kann dadurch hergestellt werden, daß zwischen dem Träger und der Glasscheibe die Solarzellen und die Schmelzkleberfolien eingelegt werden. Durch einen Temperaturvakuumprozeß werden die Schmelzkleberfolie und die Solarzellen mit dem Träger und der Glasscheibe zu einem Verbund verschmolzen. Die Schmelzkleberfolien bilden nach ihrer Verschmelzung praktisch eine einzige Folie. Als Glasscheiben können gehärtete Glasscheiben verwendet werden. Als Glasmaterial kommt Weißglas in Frage, das im Bereich des Lichtes, für das Solarzellen besonders empfindlich sind, praktisch keine Absorption aufweist. Anstelle der Glasscheibe kann auch eine durchsichtige Folie verwendet werden.

Die Herstellung eines Groß-Solarmoduls mit einer Leistung im Kilowatt-Bereich unter Verwendung von Solarmodul-Laminaten erfordert die Entwicklung einer neuen Technik. Dabei können mehrere Solarmodul-Laminate auf einem gemeinsamen Gestellrahmen mittels Klebung montiert werden. Dabei werden Haftkräfte im Bereich von einigen N/mm² erwartet. Der Kleber sollte eine Stärke im Millimeter-Bereich haben. Der Kleber sollte klimafest sein, flexibel sein und eine Demontage der Solarmodul-Laminate ermöglichen.

Der Kleber sollte Temperatur-Zyklen zwischen -40° C und +90° C aushalten. Der Kleber sollte im genannten Temperaturbereich auch bei einer relativen Luftfeuchtigkeit von 85 % Feuchte und Frost aushalten. Der Kleber sollte Klebungen zwischen einem Kunststoffträger des Solarmodul-Laminats und einem Gestellrahmen aus Metall oder Kunststoff ermöglichen.

Die genannten Aufgaben werden gelöst durch ein Verfahren nach dem Patentanspruch 1 bzw. 5.

Ausgestaltungen und Vorteile der Erfindung sind in den Unteransprüchen und der Beschreibung angegeben.

Die Zeichen "Dow Corning" und "Silastic" sind eingetragene Warenzeichen der Firma Dow Corning.

Die Silikone der Firma Dow Corning ermöglichen eine dauerhafte Klebung auch unter ungünstigen Umständen. Besonders geeignet sind Silikon-Ein-Komponenten-RTV(room temperature vulcanizing)-Produkte als Kleber. Besonders vorteilhaft sind Silikon-Klebe-Dichtungsmassen als Kleber. Vorzugsweise können SILASTIC-Massen als Kleber verwendet werden. Besonders geeignet ist der Kleber SILASTIC Q3-3744. Dieser und einige andere der genannten Kleber ermöglichen eine dauerhafte Klebung auch ohne Verwendung eines zusätzlichen Primer's auf zahlreichen Substraten.

Besonders geeignet sind nichtkorrosive Klebe-/Dichtungsmassen. Besonders geeignet sind Klebmassen mit nichtkorrosiver Vernetzungsart.

Besonders geeignet ist die nichtkorrosive Vernetzungsart für die Befestigung von Tedlar (PVF) als Rückseitenabdeckung eines Solarmodul-Laminats auf einem verzinkten Stahlträgergestell. Hervorragend geeignet dafür ist der oben bereits speziell angegebene Kleber SILASTIC Q3-3744. Solche Klebmassen sind besonders für korrosions- und vibrationsempfindliche Bauteile geeignet.

Silikone anderer Hersteller sind ebenfalls geeignet, falls sie ähnlich gute Haft- und/oder Verarbeitungseigenschaften aufweisen wie die genannten Silikone der Firma Dow Corning.

**Patentansprüche**

1. Verfahren zur Herstellung eines Groß-Solarmoduls durch Kleben von mehreren Solarmodul-Laminaten auf einem gemeinsamen Gestellrahmen,
   **gekennzeichnet durch** Verwendung eines Silikons (Silikon-Kautschuk) der Firma Dow Corning als Kleber.

2. Verfahren nach Anspruch 1,
   **gekennzeichnet durch** Verwendung eines Dow Corning-Silikon-Einkomponenten-RTV-Produkts als Kleber.

3. Verfahren nach Anspruch 1 oder 2,
   **gekennzeichnet durch** Verwendung einer Dow Corning-Silikon-Klebe/Dichtungsmasse als Kleber.

4. Verfahren nach einem der Ansprüche 1 bis 3,
   **gekennzeichnet durch** Verwendung einer Dow Corning-SILASTIC-Masse als Kleber.

5. Verfahren zur Herstellung eines Groß-Solarmoduls durch Kleben von mehreren Solarmodul-Laminaten auf einem gemeinsamen Gestellrahmen,
   **gekennzeichnet durch** Verwendung eines Silikons mit nicht-korrosiver Vernetzungsart als Kleber.

**Europäisches Patentamt**

# EUROPÄISCHER
# RECHERCHENBERICHT

Nummer der Anmeldung

## EP 91 10 2558

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-3 513 910 (SIEMENS AG) <br> * Insgesamt * <br> – – – | 1 | H 01 L 31/048 |
| X | THE CONFERENCE RECORD OF THE 14TH IEEE PHOTO-VOLTAIC SPECIALISTS CONFERENCE, San Diego, CA, 7. - 10. Januar 1980, Seiten 958-961; W.E. DENNIS: "Encapsulation of PV cells using silicone materials" <br> * Das ganze Dokument * <br> – – – | 1-3 | |
| X | THE CONFERENCE RECORD OF THE 12TH IEEE PHOTO-VOLTAIC SPECIALISTS CONFERENCE, Baton Rouge, Louisiana, 15. - 18. November 1976, Seiten 332-339; W. CARROLL et al.: "Material and design considerations of encapsulants for photovoltaic arrays in terrestrial applications" <br> * Seite 334, Spalte 1, Zeilen 31-48; Seite 334, Spalte 2, Absatz: "Cell to substrate adhesive"; Figuren 4-8 * <br> – – – | 1-3 | |
| X | THE CONFERENCE RECORD OF THE 20TH IEEE PHOTO-VOLTAIC SPECIALISTS CONFERENCE, Las Vegas, Nevada, 26. - 30. September 1988, Seiten 808-812; R.L. STATLER et al.: "The space performance of silicon vertical junction solar cells on the LIPS-III satellite" <br> * Seite 808, Spalte 2, Zeile 16 - Seite 809, Spalte 1, Zeile 23; Figuren 4-6 * <br> – – – | 1 | |
| A | THE CONFERENCE RECORD OF THE 12TH IEEE PHOTO-VOLTAIC SPECIALISTS CONFERENCE, Baton Rouge, Louisiana, 15. - 18. November 1976, Seiten 317-331; D.C. CARMICHAEL et al.: "Materials for encapsulation systems for terrestrial photovoltaic arrays" <br> * Seite 322, Spalte 1, Zeilen 15-39; Tabelle 4, seite 324; Tabel 5, seite 326; Figuren 1-3 * <br> – – – – – | 1-3 | |

**RECHERCHIERTE SACHGEBIETE (Int. Cl.5)**

H 01 L

Der vorliegende Recherchenbericht wurde für alle Patentansprüche erstellt

| Recherchenort | Abschlußdatum der Recherche | Prüfer |
|---|---|---|
| Den Haag | 17 Juni 91 | VISENTIN A. |